# EUROPÄISCHE PATENTSCHRIFT

(11) **EP 4 109 495 B1**
(45) Veröffentlichungstag und Bekanntmachung des Hinweises auf die Patenterteilung: **25.12.2024**
(21) Anmeldenummer: 22179820.0
(22) Anmeldetag: 20.06.2022
(51) Int. Cl.: H01L 21/306, H01L 21/67, H01L 29/06, H01L 29/66, H01L 29/74, H01L 29/861

(54) **VERFAHREN UND VORRICHTUNG ZUR HERSTELLUNG EINER RANDSTRUKTUR EINES HALBLEITERBAUELEMENTS**
METHOD AND DEVICE FOR FORMING AN EDGE STRUCTURE OF A SEMICONDUCTOR COMPONENT
PROCÉDÉ ET DISPOSITIF DE FABRICATION D'UNE STRUCTURE DE BORDURE D'UN COMPOSANT SEMI-CONDUCTEUR

(30) Priorität: 23.06.2021 DE 102021116206
(43) Veröffentlichungstag der Anmeldung: 28.12.2022
(73) Patentinhaber: Infineon Technologies Bipolar GmbH & Co. KG, 59581 Warstein (DE)
(72) Erfinder: GAMON, Tobias, 59581 Warstein (DE); BARTHELMESS, Reiner, 59494 Soest (DE); KELLNER-WERDEHAUSEN, Uwe, 91359 Leutenbach (DE); SOMMER, Sebastian, 44579 Castrop-Rauxel (DE)
(74) Vertreter: Westphal, Mussgnug & Partner, Patentanwälte mbB

(56) Entgegenhaltungen:
- EP-B1- 1 005 064
- GB-A- 1 031 043
- JP-A- S62 287 624
- JP-A- S62 287 625

## Beschreibung

Die vorliegende Erfindung betrifft ein Verfahren zur Herstellung einer Randstruktur eines Halbleiterbauelements gemäß dem Oberbegriff des Anspruchs 1. Außerdem betrifft die Erfindung eine Vorrichtung zur Herstellung einer Randstruktur eines Halbleiterbauelements gemäß dem Oberbegriff des Anspruchs 13.

Randstrukturen von Halbleiterbauelementen, insbesondere Leistungshalbleiterbauelemente, dienen in bekannter Weise dazu, die Sperrfähigkeit von hochsperrenden Halbleiterbauelementen, z. B. Dioden, Thyristoren, IGBTs und dergleichen, dadurch zu erhöhen, dass die maximalen elektrischen Feldstärken, die üblicherweise im oberflächennahen Randbereich des Bauelements auftreten, abgesenkt werden, um eine möglichst homogene Verteilung des elektrischen Feldes in dem Bauelement und damit eine möglichst hohe Spannungsfestigkeit des Leistungshalbleiterbauelements zu erreichen.

Häufig werden derartige Randabschlüsse dadurch hergestellt, dass ein Teil des Halbleiterkörpers in seinem Randbereich, beispielsweise im Bereich einer radial äußeren Umfangsfläche des Halbleiterkörpers, entfernt wird, um den Verlauf des elektrischen Feldes im Randbereich in vorteilhafter Weise zu beeinflussen. Insbesondere wird im Randbereich des Halbleiterkörpers durch eine Randabschrägung ein bestimmter Winkel eingestellt, unter dem beispielsweise ein pn-Übergang die Halbleiteroberfläche der Randabschrägung schneidet, wodurch der Rand von hohen elektrischen Feldstärken entlastet wird.

Um eine möglichst hohe Spannungsfestigkeit des Bauelements zu erreichen, ist es entscheidend, bei der Herstellung eines solchen Randabschlusses eine vorgegebene Form möglichst genau einzuhalten. Die hierzu eingesetzten Verfahrensschritte sind einerseits aufwändig und andererseits gestaltet sich eine exakte Reproduzierbarkeit der vorgegebenen Form häufig als schwierig. Bei herkömmlichen Verfahren werden derartige Randabschlüsse durch eine Vielzahl von Arbeitsschritten hergestellt, wobei der Halbleiterkörper zunächst in einem ersten Arbeitsschritt typischerweise mechanisch, beispielsweise durch Schleifen negativem Winkel mit hoher Genauigkeit und guter Reproduzierbarkeit hergestellt werden kann.

Die Druckschrift EP 1 005 064 B1 offenbart eine Vorrichtung zum Nassätzen einer Kante einer Halbleiterscheibe. Die Vorrichtung weist einen Träger mit einer Trägerfläche zur rotierenden Aufnahme der Halbleiterscheibe und eine oberhalb der Halbleiterscheibe angeordnete Düse auf, deren Mündungsabschnitt so ausgebildet und ausgerichtet ist, dass ein über den Mündungsabschnitt austretender Ätzflüssigkeitsstrahl unter einem Winkel > 0 und < 90 Grad zur Ebene der Halbleiterscheibe auf einen definierten Flächenabschnitt der Kante der zu behandelnden Halbleiterscheibe auftrifft.

Die Druckschrift GB 1 031 043 A offenbart, dass bei Halbleitervorrichtungen an einem Übergang zwischen einer Schicht eines Leitfähigkeitstyps und einer höher dotierten Schicht eines anderen Leitfähigkeitstyps die Oberfläche der Schicht niedrigerer Leitfähigkeit so geformt ist, dass diese Schicht im Querschnittsbereich in einer Richtung abnimmt von der Kreuzung entfernt. Dadurch soll das tangentiale elektrische Feld an der Körperoberfläche reduziert werden. Auch die Oberfläche der Schicht höherer Leitfähigkeit kann geformt sein. Die Druckschrift beschreibt verschiedene Formen, die die Oberfläche der Schichten annehmen kann. Es wird auf Vorrichtungen verwiesen, bei denen eine Schicht eines Leitfähigkeitstyps sandwichartig zwischen zwei höher leitfähigen Schichten des entgegengesetzten oder unterschiedlichen Leitfähigkeitstyps angeordnet ist. Die Schicht mit niedriger Leitfähigkeit ist so geformt, dass ihre Querschnittsfläche anfänglich in der Richtung weg von beiden Übergängen abnimmt.

Vor diesem Hintergrund liegt der vorliegenden Erfindung die Aufgabe zugrunde, ein Verfahren und eine Vorrichtung zur Herstellung einer Randstruktur eines Halbleiterbauelements bereitzustellen, die eine kostengünstige und effiziente Herstellung einer vorbestimmten Randstruktur, d. h. Kontur eines Randbereichs bzw. Randfläche, des Halbleiterbauelements mit hoher Genauigkeit und Reproduzierbarkeit ermöglichen, um u. a. eine hohe Ausbeute bei der Volumenproduktion von Halbleiterbauelementen hinsichtlich gewünschter elektrischer, mechanischer oder geometrischer Eigenschaften zu gewährleisten. Darüber hinaus sollen die mittels der verfahrensgemäß hergestellten Randstruktur erzielbaren elektrischen Eigenschaften der Bauelemente möglichst stabil gegenüber an sich unvermeidbaren Schwankungen im Herstellungsprozess sein. Außerdem sollen die erforderlichen Arbeitsschritte sowohl effizient ausführbar als auch in ihrer Anzahl insgesamt reduziert sein.

Diese Aufgabe wird durch ein Verfahren mit den Merkmalen des Anspruchs 1 und durch eine Vorrichtung mit den Merkmalen des Anspruchs 13 gelöst. Weitere vorteilhafte Ausgestaltungen der Erfindung offenbaren die jeweiligen Unteransprüche.

Es ist darauf hinzuweisen, dass die in den Ansprüchen einzeln aufgeführten Merkmale in beliebiger, technisch sinnvoller Weise miteinander kombiniert werden können (auch über Kategoriegrenzen, beispielsweise zwischen Verfahren und Vorrichtung, hinweg) und weitere Ausgestaltungen der Erfindung aufzeigen. Die Beschreibung charakterisiert und spezifiziert die Erfindung insbesondere im Zusammenhang mit den Figuren zusätzlich.

Es sei ferner darauf hingewiesen, dass eine hierin verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer negativem Winkel mit hoher Genauigkeit und guter Reproduzierbarkeit hergestellt werden kann.

Vor diesem Hintergrund liegt der vorliegenden Erfindung die Aufgabe zugrunde, ein Verfahren und eine Vorrichtung zur Herstellung einer Randstruktur eines Halbleiterbauelements bereitzustellen, die eine kostengünstige und effiziente Herstellung einer vorbestimmten Randstruktur, d. h. Kontur eines Randbereichs bzw. Randfläche, des Halbleiterbauelements mit hoher Genauigkeit und Reproduzierbarkeit ermöglichen, um u. a. eine hohe Ausbeute bei der Volumenproduktion von Halbleiterbauelementen hinsichtlich gewünschter elektrischer, mechanischer oder geometrischer Eigenschaften zu gewährleisten. Darüber hinaus sollen die mittels der verfahrensgemäß hergestellten Randstruktur erzielbaren elektrischen Eigenschaften der Bauelemente möglichst stabil gegenüber an sich unvermeidbaren Schwankungen im Herstellungsprozess sein. Außerdem sollen die erforderlichen Arbeitsschritte sowohl effizient ausführbar als auch in ihrer Anzahl insgesamt reduziert sein.

Diese Aufgabe wird durch ein Verfahren mit den Merkmalen des Anspruchs 1 und durch eine Vorrichtung mit den Merkmalen des Anspruchs 13 gelöst. Weitere vorteilhafte Ausgestaltungen der Erfindung offenbaren die jeweiligen Unteransprüche.

Es ist darauf hinzuweisen, dass die in den Ansprüchen einzeln aufgeführten Merkmale in beliebiger, technisch sinnvoller Weise miteinander kombiniert werden können (auch über Kategoriegrenzen, beispielsweise zwischen Verfahren und Vorrichtung, hinweg) und weitere Ausgestaltungen der Erfindung aufzeigen. Die Beschreibung charakterisiert und spezifiziert die Erfindung insbesondere im Zusammenhang mit den Figuren zusätzlich.

Es sei ferner darauf hingewiesen, dass eine hierin verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Außerdem soll ein hierin verwendeter Begriff "etwa" einen Toleranzbereich angeben, den der auf dem vorliegenden Gebiet tätige Fachmann als üblich ansieht. Insbesondere ist unter dem Begriff "etwa" ein Toleranzbereich der bezogenen Größe von bis maximal +/-20 %, bevorzugt bis maximal +/-10 % zu verstehen.

Des Weiteren sind im Sinne der Erfindung hierin verwendete relative Begriffe bezüglich eines Merkmals, zum Beispiel "größer, "kleiner", "höher, "niedriger", "schneller", "langsamer" und dergleichen, stets so auszulegen, dass herstellungs- und/oder durchführungsbedingte Größenabweichungen des betreffenden Merkmals, die innerhalb der für die Fertigung bzw. Durchführung des jeweiligen Merkmals definierten Fertigungs-/Durchführungstoleranzen liegen, nicht von dem jeweiligen relativen Begriff erfasst sind. Mit anderen Worten ist eine Größe eines Merkmals erst dann als im Sinne der Erfindung "größer, "kleiner", "höher", "niedriger", "schneller", "langsamer" und dergleichen anzusehen als eine Größe eines Vergleichsmerkmals, wenn sich die beiden Vergleichsgrößen in ihrem Wert so deutlich voneinander unterscheiden, dass dieser Größenunterschied sicher nicht in den fertigungs-/durchführungsbedingten Toleranzbereich des betreffenden Merkmals fällt, sondern das Ergebnis zielgerichteten Handelns ist.

Erfindungsgemäß weist ein Verfahren zur Herstellung einer Randstruktur eines Halbleiterbauelements, wie z. B. Dioden, Thyristoren und dergleichen, die Schritte auf:
- Bereitstellen eines Halbleiterkörpers des Halbleiterbauelements, der wenigstens zwei zueinander beabstandete Hauptflächen mit jeweils einem Rand aufweist, zwischen welchen Rändern sich eine Randfläche erstreckt, und
- Ätzen einer vorbestimmten Randkontur durch Auftragen eines chemischen Ätzmittels gezielt auf die Randfläche mittels eines Ätzmittelstrahls bei gleichzeitiger Rotation des Halbleiterkörpers um eine Rotationsachse.

Weiter wird der Ätzmittelstrahl gemäß der Erfindung mit einem vorbestimmten Strahlquerschnitt derart tangential gerichtet zur Randfläche geführt, dass der Ätzmittelstrahl lediglich mit einem Teil seines Strahlquerschnitts auf die Randfläche auftrifft. Ein Durchmesser des Ätzmittelstrahls ist dabei kleiner als ein Abstand der die Randfläche begrenzenden Ränder der jeweiligen Hauptflächen.

Als Randkontur ist im erfindungsgemäßen Sinn eine in einem Querschnitt des Halbleiterkörpers definierbare Umrisslinie des Halbleiterkörpers in seinem Randbereich zu verstehen. Die Randkontur definiert den Verlauf der Randfläche im Randbereich des Halbleiterkörpers. Hierbei ist insbesondere der Verlauf im Wesentlichen senkrecht zu der durch die Rotation des Halbleiterkörpers festgelegten Tangentialrichtung (hierin auch als Umfangsrichtung des Halbleiterkörpers bzw. der Randfläche bezeichnet) zu verstehen.

Im idealen (mathematischen) Fall ist eine Tangente eine Gerade, die eine gegebene Kurve (insbesondere eine Kurve der Randfläche) in einem bestimmten Punkt berührt. Da aber der Ätzmittelstrahl strenggenommen keine Gerade im mathematischen Sinn beschreibt und darüber hinaus auch einen zweidimensionalen Durchmesser (d. h. Strahlquerschnitt) aufweist, ist im Sinne der Erfindung unter dem tangential zur Randfläche gerichtet geführten Ätzmittelstrahl eine geometrische Beziehung zwischen Randfläche und Ätzmittelstrahl derart zu verstehen, dass ein Teil des Ätzmittelstrahls (d. h. ein Teil des Strahlquerschnitts) einen Punkt bzw. einen flächig ausgedehnten Bereich der Randfläche (hierin auch als Auftreffort bezeichnet) berührt. Der den Auftreffort der Randfläche nicht berührende Teil des Ätzmittelstrahls passiert die Randfläche, ohne im Wesentlichen an einer direkten chemischen Ätzwirkung auf die Randfläche beteiligt zu sein. Der Ätzmittelstrahl trifft die Randfläche somit nicht mit seinem vollen Strahlquerschnitt, sondern lediglich mit einem Teil hiervon.

Die vorbeschriebene tangentiale Ausrichtung des Ätzmittelstrahls zur Randfläche ermöglicht eine gezielte Kontrolle und Steuerung, z. B. Verringerung, einer herkömmlich im Wesentlichen unkontrollierbaren Spreizung des Ätzmittelstrahls nach dem Auftreffen auf die Randfläche infolge eines Wegspritzens des Ätzmittels vom Auftreffort. Der Auftreffort des Ätzmittels auf die Randfläche, der im Wesentlichen einem Benetzungsbereich entspricht, in dem das Ätzmittel unmittelbar seine Ätzwirkung auf den Halbleiterkörper entfaltet, ist erfindungsgemäß lokal gezielt sehr genau begrenzbar. Zudem wird wirksam verhindert, dass das auf die Randfläche auftreffende Ätzmittel unbeabsichtigt und unkontrolliert die Hauptflächen des Halbleiterkörpers erreicht und diese hierdurch beschädigt. Damit kann ein Aufbringen einer Maske auf nicht zu ätzende Bereiche, z. B. Hauptflächen, Ober- und/oder Unterseite des Halbleiterkörpers, entfallen, wodurch die Anzahl der erforderlichen Verfahrensschritte reduziert wird und das Verfahren insgesamt einfacher ausgeführt werden kann.

Die hierin offenbarte tangentiale Führung des Ätzmittelstrahls zum zu ätzenden Randbereich des Halbleiterkörpers lässt sich mit entsprechenden Steuer- und ggfs. Sensormitteln automatisieren, so dass eine hochgenaue Reproduktion der Randstruktur gewährleistet werden kann, die dem hergestellten Bauelement die vorbestimmten elektrischen, mechanischen, geometrischen Eigenschaften verleiht. Die Randabschrägung kann somit vollständig durch den Ätzprozess hergestellt werden, ohne dass beispielsweise eine mechanische Vor- und/oder Nachbearbeitung der Randfläche notwendig wäre. Der hohe Automatisierungsgrad steigert die Effizienz der Bauteilfertigung infolge kurzer Bearbeitungszyklen, die insbesondere bei der Herstellung großer Stückzahlen von besonderem Vorteil ist. Die Bauteilfertigungskosten lassen sich signifikant reduzieren.

Der Halbleiterkörper kann geometrisch im Wesentlichen rotationssymmetrisch in Bezug auf die Rotationsachse ausgebildet sein, also zum Beispiel (kreis-)zylinder- oder scheibenförmig. Im Fall eines zylinder- oder scheibenförmigen Körpers können seine beiden Grundflächen, d. h. seine Ober- und Unterseite, jeweils eine der Hauptflächen im Sinne der Erfindung bilden und die Mantelfläche des zylinder- oder scheibenförmigen Körpers bzw. ein Teil der Mantelfläche kann die Randfläche im Sinne der Erfindung bilden. Die Erfindung ist jedoch nicht zwingend auf eine solche Ausgestaltung und Anordnung der jeweiligen Flächen beschränkt.

Das Halbleiterbauelement kann bevorzugt ein symmetrisch sperrendes, bipolares Bauelement (d. h. wenigstens zwei pn-Übergänge aufweisend), wie z. B. ein Thyristor, oder ein asymmetrisch sperrendes, insbesondere bipolares Bauelement (d. h. lediglich einen pn-Übergang aufweisend), wie z. B. eine Diode und dergleichen, sein, und für Sperrspannungen von beispielsweise etwa 3,6 kV und mehr ausgelegt sein, ohne jedoch zwingend hierauf beschränkt zu sein.

Die Hauptflächen des Halbleiterkörpers können beispielsweise als Kathoden- und Anodenflächen z. B. eines Thyristors, einer Diode und dergleichen ausgebildet sein, wobei die Erfindung nicht zwingend hierauf beschränkt ist. Die Randfläche des Halbleiterkörpers kann sich als äußere Umfangfläche zwischen der Kathoden- und Anodenfläche erstrecken.

Besonders vorteilhaft kann das Verfahren zur Volumenfertigung von Halbleiterbauelementen mit einer Stückzahl von beispielsweise etwa 25.000 pro Jahr und mehr verwendet werden.

Nach einer vorteilhaften Weiterbildung des Erfindungsgegenstands wird als die Randkontur mittels dem Ätzmittelstrahl eine Randabschrägung geätzt, deren Verlauf von einem ursprünglichen, vor dem Ätzen vorhandenen Konturverlauf der Randfläche, makroskopisch betrachtet, verschieden ist. Mit anderen Worten ist der durch die Ätzwirkung des Ätzmittels bewirkte Materialabtrag im Randbereich des Halbleiterkörpers nicht überall gleich. Vielmehr ist der Materialabtrag in einem Abschnitt des Randbereichs größer/kleiner als in einem anderen Abschnitt des Randbereichs.

Im Gegensatz hierzu verändert ein im Wesentlichen konstanter Materialabtrag über die gesamte Randfläche ihre ursprüngliche, vor dem Ätzvorgang vorhandene Randkontur makroskopisch betrachtet nicht.

Der durch das Ätzen bewirkte Materialabtrag im Randbereich des Halbleiterkörpers kann abschnittsweise konstant und abschnittsweise nicht konstant sein, wodurch sich die geätzte Randkontur in ihrem Verlauf jedoch von der ursprünglichen Randkontur unterscheidet. Ein konstanter Materialabtrag ermöglicht die Ausbildung einer geraden Randkontur in nicht-umfänglicher/nicht-tangentialer Richtung des Halbleiterkörpers (dementsprechend in radialer und/oder axialer Richtung). Der durch das Ätzen bewirkte Materialabtrag im Randbereich kann ebenso über den gesamten Randbereich in nicht-umfänglicher/nicht-tangentialer Richtung nicht konstant sein, so dass sich auch ein gekrümmter, bogenförmiger Verlauf der Randkontur in nicht-umfänglicher/nicht-tangentialer Richtung des Halbleiterkörpers bereitstellen lässt.

Beträgt der Umfang des gewünschten Materialabtrags im Randbereich in radialer Richtung des Halbleiterkörpers mehr als der maximale Strahlquerschnitt des Ätzmittelstrahls, kann der Ätzmittelstrahl in radialer Richtung unter Beibehaltung seiner tangentialen Ausrichtung zur Randfläche nachgeführt werden. Hierzu kann der Ätzmittelstrahl zum Beispiel translatorisch und/oder rotatorisch in radiale Richtung zur Randfläche im Raum verlagert werden. Die Nachführungsgeschwindigkeit des Ätzmittelstrahls kann hierbei so gewählt werden, dass er der durch die Ätzwirkung entstehenden Kontur im Randbereich folgt.

Zusätzlich oder alternativ zur vorbeschriebenen radialen Verlagerung des Ätzmittelstrahls kann ein gewünschter Materialabtrag im Randbereich in axialer Richtung des Halbleiterkörpers vorgenommen werden, indem der Ätzmittelstrahl translatorisch und/oder rotatorisch in axiale Richtung des Halbleiterkörpers verlagert wird, um den Auftreffort des Ätzmittelstrahls auf den Randbereich in axialer Richtung des Halbleiterkörpers (d. h. im Wesentlichen parallel zur Rotationsachse) zu verändern.

In einer weiteren vorteilhaften Ausgestaltung der Erfindung ist die geätzte Randabschrägung eine so genannte doppelt-positive Randabschrägung. Die doppelt-positive Randabschrägung ist dadurch gekennzeichnet, dass sie in Bezug auf die Hauptflächen, die die Randfläche begrenzen, ins Innere des Halbleiterkörpers zurücktritt, z. B. nach Art einer Rille, Nut, Hohlkehle o. ä. Bei der doppelt-positiven Randabschrägung können die Hauptflächen des Halbleiterkörpers in vorteilhafter Weise flächenmäßig im Wesentlichen (vollständig) erhalten bleiben. Die Ausbildung der doppelt-positiven Randabschrägung erfordert einen deutlich kleineren Siliziumbereich des Halbleiterkörpers als zum Beispiel eine so genannte negative oder positiv-negative Randabschrägung, deren Ausbildung stets mit einer wesentlichen Verkleinerung der Hauptflächen einhergeht.

Des Weiteren sind die mit der doppelt-positiven Randabschrägung erzielbaren elektrischen Eigenschaften des Halbleiterbauelements selbst bei auftretenden Prozessschwankungen (d. h. Prozesstoleranzen) deutlich stabiler einstellbar, so dass das Verfahren in seiner Durchführung noch weiter vereinfacht werden kann, ohne sich nachteilig auf die Qualität der hergestellten Halbleiterbauelemente auszuwirken. Eine hohe Ausbeute kann weiterhin gewährleistet werden.

Die doppelt-positive Randabschrägung kann in Bezug auf eine Dicke des Halbleiterkörpers (d. h. ein Abstand zwischen den Hauptflächen) im Wesentlichen symmetrisch und mittig zwischen den Hauptflächen angeordnet und ausgebildet sein. Die Erfindung ist jedoch nicht zwingend hierauf beschränkt. Die Randabschrägung kann auch außermittig zwischen den Hauptflächen und/oder asymmetrisch angeordnet und/oder ausgebildet sein.

Dementsprechend sieht eine alternative Ausgestaltung der Erfindung vor, dass die geätzte Randabschrägung eine asymmetrische Randabschrägung ist.

Eine andere vorteilhafte Weiterbildung des Erfindungsgegenstands sieht vor, dass die Randkontur in wenigstens zwei unterschiedlichen Ätzschritten, z. B. einem ersten Ätzschritt und einem zweiten Ätzschritt, geätzt wird, wobei zwischen den Ätzschritten wenigstens ein Parameter aus der Gruppe aufweisend einen Durchmesser des Strahlquerschnitts, einen Volumenstrom des Ätzmittelstrahls, d. h. das Volumen des Ätzmittels, das pro Zeitspanne durch einen festgelegten Querschnitt transportiert wird, und eine Rotationsgeschwindigkeit des Halbleiterkörpers verändert wird.

Beispielsweise kann der Durchmesser des Strahlquerschnitts während des ersten Ätzschritts gezielt kleiner gewählt werden als der Durchmesser des Strahlquerschnitts während des zweiten Ätzschritts. Der kleinere Strahlquerschnitt ermöglicht es, die Spreizung des Ätzmittelstrahls nach dem Auftreffen auf die Randfläche stark zu begrenzen, wodurch die Ätzwirkung gezielt auf einen sehr schmalen Bereich der Randfläche begrenzt werden kann. Zudem erhöht der kleinere Strahlquerschnitt den Freiheitsgrad bei der Herstellung einer konkreten Form der Randkontur. Der gewünschte Verlauf der Randkontur kann zielsicher und präzise in die Randfläche eingebracht werden.

Im zweiten Ätzschritt kann die Spreizung des auftreffenden Ätzmittelstrahl durch die Vergrößerung des Strahlquerschnitts gezielt erhöht werden. Auf diese Weise lassen sich während des ersten Ätzschritts ggfs. entstandene Ablaufspuren des Ätzmittels und/oder Inhomogenitäten in/auf der Randfläche effektiv beseitigen. Der breitere Strahlquerschnitt kann, ohne jedoch zwingend hierauf beschränkt zu sein, im zweiten Ätzschritt vorzugsweise derart gewählt werden, dass der Ätzmittelstrahl im Wesentlichen die gesamte Oberfläche der geätzten Randkontur benetzt und infolge der nun auf die gesamte Randfläche gleichmäßig ausgeübten Ätzwirkung eine Homogenisierung (z. B. Glättung) der geätzten Randfläche erzielt.

Jedenfalls führt der größere Strahlquerschnitt zu einer homogeneren Ätzwirkung und kann in dieser Art vorteilhaft zum Polierätzen der Randfläche, d. h. zum chemischen Abtragen von Rauheitsspitzen an der Oberfläche der Randfläche, eingesetzt werden. Besonders bevorzugt kann das Polierätzen mit großem Strahlquerschnitt des Ätzmittelstrahls als ein abschließender, letzter Ätzschritt nach einem oder mehreren vorausgegangenen Ätzschritten ausgeführt werden. Zusätzliche oder alternative Möglichkeiten zur gezielten Vergrößerung der Spreizung sind durch die Rotationsgeschwindigkeit und den Volumenstrom gegeben (nachfolgend beschrieben). Diese können daher gleichfalls zum Polierätzen der Randfläche eingesetzt werden.

Besonders bevorzugt kann in einem ersten Ätzschritt die Randfläche wenigstens teilweise geglättet werden. Hierzu kann die Spreizung des auftreffenden Ätzmittelstrahls vorteilhafterweise vergrößert werden, zum Beispiel durch einen größeren Strahlquerschnitt als beispielsweise beim Ätzen der Randabschrägung selbst. Zusätzliche oder alternative Möglichkeiten zur gezielten Vergrößerung der Spreizung sind durch die Rotationsgeschwindigkeit und den Volumenstrom gegeben (nachfolgend beschrieben). Diese können daher gleichfalls zur Glättung der Randfläche eingesetzt werden.

Bei der bevorzugten Ausbildung der doppelt-positiven Randabschrägung kann mit dem kleineren Strahlquerschnitt zunächst die rillen- oder nutartige Vertiefung in die Randfläche eingebracht werden, wobei der Ätzmittelstrahl mit größerem Durchmesser im zweiten Ätzschritt zusätzlich von den seitlichen Flanken der rillen- oder nutartigen doppelt-positiven Randabschrägung begrenzt und entsprechend kontrolliert geführt ist.

Alternativ oder zusätzlich zur Änderung des Strahlquerschnitts kann die Rotationsgeschwindigkeit, mit welcher der Halbleiterkörper während des Ätzvorgangs gedreht wird, z. B. während des ersten Ätzschritts größer gewählt werden als die Rotationsgeschwindigkeit z. B. während des zweiten Ätzschritts (oder umgekehrt). Die höhere Rotationsgeschwindigkeit des Halbleiterkörpers bewirkt ebenfalls eine starke Begrenzung der Spreizung des Ätzmittelstrahls nach dem Auftreffen auf die Randfläche. Im zweiten Ätzschritt wird eine größere Spreizung des Ätzmittelstrahls durch Verringern der Rotationsgeschwindigkeit gezielt zugelassen, um die bereits vorstehend beschriebene Wirkung (d. h. Homogenisierung, Glättung) zu erzielen.

Alternativ oder zusätzlich zur Änderung des Strahlquerschnitts und/oder zur Änderung der Rotationsgeschwindigkeit des Halbleiterkörpers kann der Volumenstrom des Ätzmittelstrahls z. B. während des ersten Ätzschritts kleiner gewählt werden als der Volumenstrom z. B. während des zweiten Ätzschritts (oder umgekehrt). Durch Aufbringen der geringeren Menge des Ätzmittels im ersten Ätzschritt wird die Spreizung des Ätzmittelstrahls nach dem Auftreffen auf die Randfläche stark begrenzt. Im zweiten Ätzschritt kann durch die größere Ätzmittelmenge je Zeiteinheit eine größere Spreizung des Ätzmittelstrahls gezielt zugelassen werden, um die vorteilhafte Wirkung der Homogenisierung bzw. Glättung der Randkontur zu erzielen.

Eine noch weitere vorteilhafte Ausgestaltung der Erfindung sieht vor, dass der maximale Strahlquerschnitt des auszubringenden Ätzmittelstrahls auf einen Durchmesser von höchstens etwa 50 %, bevorzugt zwischen etwa 10 % und etwa 30 %, eines Abstands der die Randfläche begrenzenden Ränder der jeweiligen Hauptflächen begrenzt wird. Der Abstand entspricht einer Dicke des Halbleiterkörpers, wo die Hauptflächen des Halbleiterkörpers beabstandet zueinander im Wesentlichen parallel angeordnet sind. Diese Begrenzung des Strahlquerschnitts kann bei Kombination mit der Unterteilung des gesamten Ätzvorgangs in die hierin beschriebenen ersten und zweiten Ätzschritte besonders vorteilhaft für den ersten Ätzschritt gelten, bei dem der Strahlquerschnitt kleiner gewählt wird als im zweiten Ätzschritt. Zwar können mit einem im Strahlquerschnitt derart begrenzten Ätzmittelstrahl, mit dem der Verlauf der Randkontur zwar präzise ausgebildet werden kann, zunächst Ablaufspuren (d. h. Inhomogenitäten) an der Halbleiteroberfläche entstehen. Diese können jedoch im zweiten Ätzschritt mit einem größeren Strahlquerschnitt des Ätzmittelstrahls effektiv beseitigt werden, wie bereits an anderer Stelle beschrieben ist.

Gemäß einer vorteilhaften Weiterbildung des Erfindungsgegenstands wird als die Randkontur mittels dem Ätzmittelstrahl wenigstens ein Teil der Randfläche lediglich geglättet, wobei ein ursprünglicher, vor dem Ätzen vorhandener Konturverlauf des geglätteten Teils der Randfläche, makroskopisch betrachtet, unverändert erhalten bleibt. Mit anderen Worten wird bei der reinen Glättung lediglich ein geringer Bereich der Randfläche chemisch abgetragen, um die Randoberfläche zu glätten. Zum Beispiel kann eine raue Randoberfläche (auch als "Damage" bezeichnet) durch ein Schneiden (z. B. Laserschneiden) des Halbleiterbauelements aus einem Vorprozess, d. h. vor dem eigentlichen Ätzvorgang, entstanden sein. Dieser "Damage" kann vorteilhaft mit dem hierin offenbarten Verfahren ebenfalls entfernt werden. Zum Entfernen des "Damage" bzw. der Oberflächenrauigkeit der Randoberfläche kann der Strahlquerschnitt vorzugsweise einen größeren Durchmesser aufweisen als beispielsweise beim Ätzen einer Randabschrägung. Der größere Strahlquerschnitt bewirkt eine homogenere Ätzwirkung als ein Strahlquerschnitt kleineren Durchmessers.

Sofern die gesamte Randfläche ausschließlich geglättet wird, ändert sich der Verlauf der Randkontur makroskopisch betrachtet durch das Ätzen im Wesentlichen nicht, da über die gesamte Randfläche lediglich der "Damage" gleichmäßig entfernt wird. Wird jedoch nur ein Teil der Randfläche geglättet und zusätzlich eine Randabschrägung, zum Beispiel die doppelt-positive Randabschrägung, in die Randfläche eingebracht, verändert sich der Verlauf der Randkontur im Bereich der eingebrachten Randabschrägung durch das Ätzen im Vergleich zum ursprünglichen Verlauf der Randkontur in diesem Bereich.

Vorteilhafterweise ist eine Rotationsrichtung des Halbleiterkörpers an einem Auftreffort des Ätzmittelstrahls auf die Randfläche im Wesentlichen gleich wie eine Strahlrichtung des Ätzmittelstrahls. Mit anderen Worten stimmen am Auftreffort die Tangentialrichtungen der Rotationsbewegung und des Ätzmittelstrahls im Wesentlichen überein, wodurch die Spreizung des auf die Randfläche am Auftreffort auftreffenden Ätzmittelstrahls sehr genau in der hierin offenbarten Weise kontrolliert werden kann.

Zusätzlich oder alternativ kann dem Ätzmittel ein Additiv zur Herabsetzung seiner Oberflächenspannung hinzugefügt werden, wodurch die Benetzungseigenschaften des Ätzmittelstrahls beim Auftreffen auf die Randfläche gezielt beeinflusst werden können, z. B. die vom Ätzmittel während der Kontaktdauer, d. h. nach dem Auftreffen und vor dem anschließenden Abschleudern, benetzbare Flächengröße der Randfläche, das Spreizen des Ätzmittelstrahls nach dem Auftreffen auf die Randfläche und dergleichen.

Nach einer bevorzugten Ausgestaltung wird die Rotationsachse im Wesentlichen lotrecht im Raum ausgerichtet. Eine alternative Ausgestaltung sieht vor, die Rotationsachse im Wesentlichen waagerecht im Raum auszurichten. In beiden Ausgestaltungen kann die Wirkung der Schwerkraft je nach Anordnung der zu ätzenden Randfläche zusätzlich zur Verstärkung der erfindungsgemäßen Eigenschaften und Wirkungen genutzt werden. Beispielsweise kann die Schwerkraft genutzt werden, das Ablaufen oder Abschleudern des auf die Randfläche aufgetragenen Ätzmittels und/oder die Verweildauer (d. h. Einwirkdauer) des Ätzmittels auf der Randfläche zusätzlich gezielt zu beeinflussen. Es kann aufgrund der Schwerkraftwirkung ebenfalls möglich sein, den Halbleiterkörper bei lotrechter Anordnung der Rotationsachse mit einer höheren Geschwindigkeit rotieren zu müssen als bei waagerechter Anordnung der Rotationsachse, um beispielsweise ein ausreichend schnelles Abschleudern des Ätzmittels nach dem Auftragen auf die Randfläche zu bewirken und hierdurch ein durch den Einfluss der Schwerkraft beeinflusstes, unerwünschtes Ablaufen des Ätzmittels auf der Randfläche zu verringern bzw. zu verhindern. Andererseits kann eine geringere Rotationsgeschwindigkeit vorteilhaft genutzt werden, Halbleiterkörper mit einem größeren Durchmesser zu rotieren, um die auf den Halbleiterkörper einwirkenden Fliehkräfte zu reduzieren.

Gemäß einem weiteren Aspekt der Erfindung weist eine Vorrichtung zur Herstellung einer Randstruktur eines Halbleiterbauelements einen rotierbaren Träger zum Halten eines Halbleiterkörpers des Halbleiterbauelements, wenigstens eine steuerbare Düse zum Ausgeben eines Ätzmittelstrahls mit einem vorbestimmten Strahlquerschnitt und eine Steuereinheit auf. Die Steuereinheit ist ausgebildet, den Träger und/oder die wenigstens eine Düse mittels eines Verfahrens gemäß einer der offenbarten Ausgestaltungen zu steuern, das heißt, insbesondere den Ätzmittelstrahl derart tangential gerichtet zur Randfläche zu führen, dass der Ätzmittelstrahl lediglich mit einem Teil seines Strahlquerschnitts auf die Randfläche auftrifft.

Es ist darauf hinzuweisen, dass bezüglich vorrichtungsbezogener Begriffsdefinitionen sowie der Wirkungen und Vorteile vorrichtungsgemäßer Merkmale vollumfänglich auf die Offenbarung sinngemäßer Definitionen, Wirkungen und Vorteile des hierin offenbarten erfindungsgemäßen Herstellungsverfahrens Bezug genommen werden kann. Das heißt, Offenbarungen hierin bezüglich des erfindungsgemäßen Herstellungsverfahrens können in sinngemäßer Weise ebenso zur Definition der erfindungsgemäßen Vorrichtung herangezogen werden und umgekehrt, sofern dies nicht ausdrücklich ausgeschlossen ist. Insofern kann auf eine Wiederholung von Erläuterungen sinngemäß gleicher Merkmale, deren Wirkungen und Vorteile zugunsten einer kompakteren Beschreibung verzichtet werden, ohne dass derartige Auslassungen als Einschränkung auszulegen wären.

Die Düse kann derart ausgebildet sein, ihre Lage und/oder Winkelausrichtung im Raum steuerbar zu verändern. Die Düse kann alternativ oder zusätzlich ausgebildet sein, Eigenschaften des Ätzmittelstrahls steuerbar zu verändern, z. B. den Strahlquerschnitt, einen Volumenstrom, Druck und/oder Temperatur des Ätzmittels.

Eine vorteilhafte Ausgestaltung der Erfindung sieht vor, dass umfänglich um den Träger mehrere Düsen verteilt, insbesondere äquidistant verteilt, angeordnet sind. Beispielsweise können bevorzugt zwei bis vier Düsen umfänglich um den Träger verteilt angeordnet sein. Besonders bevorzugt können drei Düsen äquidistant um den Träger verteilt angeordnet sein. Das Vorsehen mehrerer Düsen vergrößert die pro Zeiteinheit auf die Randfläche erzielbare Ätzwirkung, das heißt den Materialabtrag, wodurch die Zeit zum vollständigen Ausbilden der gewünschten Randkontur je Halbleiterbauelement nochmals deutlich verringert wird.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird. In dieser Zeichnung zeigen schematisch:
- Fig. 1: eine Seitenansicht einer Hälfte eines beispielhaften Halbleiterkörpers eines Halbleiterbauelements vor dem Ätzen einer Randstruktur,
- Fig. 2: einen Zwischenschritt in einer Seitenansicht des Halbleiterkörpers 1 aus Fig. 1 nach einer teilweisen Ausführung eines beispielhaften Verfahrens zur Herstellung einer Randstruktur gemäß der Erfindung,
- Fig. 3: eine Seitenansicht des Halbleiterkörpers aus Fig. 2 mit der nach dem Ausführungsbeispiel des erfindungsgemäßen Verfahrens aus Fig. 2 vollständig gefertigten Randstruktur,
- Fig. 4: eine Seitenansicht eines beispielhaften Halbleiterkörpers eines Halbleiterbauelements mit einer nach einem Ausführungsbeispiel des erfindungsgemäßen Verfahrens vollständig gefertigten alternativen Randstruktur,
- Fig. 5: eine Seitenansicht (A) eines Ausführungsbeispiels einer Vorrichtung zur Herstellung einer Randstruktur gemäß der Erfindung und eine Draufsicht (B) auf die Vorrichtung aus Ansicht (A) und
- Fig. 6: eine Draufsicht auf ein weiteres Ausführungsbeispiel einer Vorrichtung zur Herstellung einer Randstruktur gemäß der Erfindung.

In den unterschiedlichen Figuren sind hinsichtlich ihrer Funktion gleichwertige Teile stets mit denselben Bezugszeichen versehen, so dass diese in der Regel auch nur einmal beschrieben werden.

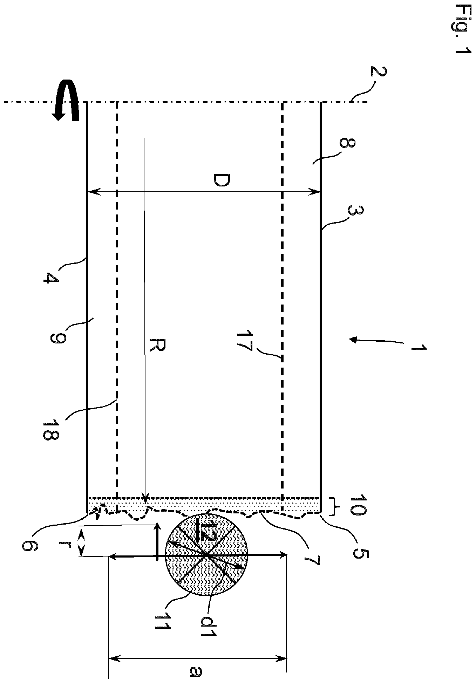

Fig. 1 stellt eine Seitenansicht einer Hälfte eines beispielhaften Halbleiterkörpers 1 eines Halbleiterbauelements vor dem Ätzen einer Randstruktur dar. Das Halbleiterbauelement kann zum Beispiel ein symmetrisch sperrendes, insbesondere bipolares Bauelement (d. h. beispielsweise wenigstens zwei pn-Übergänge aufweisend) sein, z. B. ein Thyristor, oder ein asymmetrisch sperrendes, insbesondere bipolares Bauelement mit lediglich einem pn-Übergang, wie eine Diode und dergleichen, und für Sperrspannungen von beispielsweise etwa 3,6 kV und mehr ausgelegt sein. Die Erfindung ist jedoch nicht zwingend auf Halbleiterbauelemente mit den vorgenannten Merkmalen beschränkt.

Vorliegend ist der dargestellte Halbleiterkörper 1 im Wesentlichen zylinderförmig ausgebildet. Aufgrund seiner im Wesentlichen rotationssymmetrischen Gestalt ist der Halbleiterkörper 1 in Fig. 1 lediglich auf einer Seite seiner Mittelachse 2 bzw. Symmetrieachse dargestellt. Die Mittelachse 2 ist gleichzeitig eine Rotationsachse, um die der Halbleiterkörper 1 rotiert werden kann, wie nachstehend noch ausführlicher beschrieben werden wird.

Der in Fig. 1 gezeigte, beispielhaft zylinderförmige Halbleiterkörper 1 weist eine erste scheibenförmige Hauptfläche 3 und eine zweite scheibenförmige Hauptfläche 4 auf. Die erste Hauptfläche 3 kann beispielsweise eine lediglich schematisch angedeutete Kathodenstruktur 8 des Halbleiterbauelements (z. B. Diode, Thyristor etc.) ausbilden, die zweite Hauptfläche 4 beispielsweise eine ebenfalls nur schematisch angedeutete Anodenstruktur 9 des Halbleiterbauelements. Hierzu können die Halbleiterbereiche 8 und 9 jeweils in an sich wohl bekannter Weise mit Dotierstoffen versehen sein, um gewünschte Leitungseigenschaften (z. B. p-/n-Leitung) und/oder Halbleiterübergänge zwischen unterschiedlichen Leitungstypen (z. B. pn-/pnp-Übergang etc.) bereitzustellen.

In Fig. 1 sind die beiden Hauptflächen 3 und 4 erkennbar beabstandet zueinander angeordnet, vorliegend verlaufen sie zudem parallel, ohne jedoch zwingend hierauf beschränkt zu sein. Die erste Hauptfläche 3 weist einen radial außenliegenden und diese begrenzenden Rand 5 auf, die zweite Hauptfläche 4 einen radial außenliegenden und diese begrenzenden Rand 6. Zwischen den Rändern 5 und 6 der beiden Hauptflächen 3 bzw. 4 erstreckt sich eine Randfläche 7 des Halbleiterkörpers 1.

Der Abstand der beiden Hauptflächen 3 und 4 zueinander entspricht vorliegend einer Dicke D des Halbleiterkörpers 1. Der Abstand der Randfläche 7 zur Mittelachse 2 entspricht im Wesentlichen einem Radius *R* des Halbleiterkörpers 1.

Im Halbleiterkörper 1 der gezeigten Ausführungsvariante sind beispielhaft zwei pn-Übergänge 17 und 18 zu erkennen, wie sie in dieser oder ähnlicher Weise bei einem symmetrisch sperrenden Bauelement wie z. B. einem Thyristor vorgesehen sein können. Die Erfindung ist nicht zwingend auf das Vorhandensein von zwei pn-Übergängen beschränkt. Es können weniger oder mehr als zwei pn-Übergänge im Halbleiterkörper 1 vorgesehen sein. Es sei darauf hingewiesen, dass der Abstand der pn-Übergänge 17 und 18 zu den jeweiligen Hauptflächen 3 bzw. 4 nicht maßstabsgetreu dargestellt ist.

In Fig. 1 ist eine Oberflächenrauigkeit der Randfläche 7 durch die gezackte Strichlinierung angedeutet, allerdings nicht maßstäblich. Die raue Randoberfläche, die auch als "Damage" bezeichnet wird, kann beispielsweise durch Schneiden des Halbleiterkörpers 1 aus einem Vorprozess entstanden sein, d. h. vor dem nachstehend beschriebenen eigentlichen Ätzvorgang zur Ausbildung einer Randkontur. Die Rauigkeit der Randfläche 7 weist im Wesentlichen eine Ausdehnung in einer radialen Richtung des Halbleiterkörpers 1 auf, die mit dem Bezugszeichen 10 in Fig. 1 angegeben ist.

In Fig. 1 ist weiterhin ein Ätzmittelstrahl 11 zu erkennen, dessen Strahlrichtung in die Zeichenebene weist. Der Ätzmittelstrahl 11 ist damit tangential zur Randfläche 7 ausgerichtet. Der Ätzmittelstrahl 11 weist einen (vorliegend im Wesentlichen kreisförmigen) Strahlquerschnitt 12 mit einem Durchmesser *d1* auf. Einem den Ätzmittelstrahl 11 bildenden chemischen Ätzmittel kann ein Additiv zur Herabsetzung seiner Oberflächenspannung hinzugefügt sein, ohne jedoch zwingend hierauf beschränkt zu sein.

Um eine vorbestimmte Randkontur, d. h. einen vorbestimmten Verlauf der Randfläche 7, durch einen Materialabtrag an der Randfläche 7 zu ätzen, wird das chemische Ätzmittel gezielt auf die Randfläche 7 mittels des Ätzmittelstrahls 11 aufgetragen, wobei der Halbleiterkörper 1 gleichzeitig um die Rotationsachse 2 rotiert wird. Im vorliegenden Fall stimmen die Rotationsrichtung des Halbleiterkörpers 1 sowie die Strahlrichtung des Ätzmittelstrahls 11 am Auftreffort des Ätzmittelstrahls 11 auf die Randfläche 7 im Wesentlichen überein.

Weiter ist in Fig. 1 dargestellt, dass der Ätzmittelstrahl 11 während des Ätzvorgangs zur Ausbildung der Randkontur derart tangential gerichtet zur Randfläche 7 geführt wird, dass der Ätzmittelstrahl 11 lediglich mit einem Teil seines Strahlquerschnitts 12 auf die Randfläche 7 auftrifft. Die tangentiale Ausrichtung des Ätzmittelstrahls 11 zur Randfläche 7 gemäß der Erfindung ermöglicht, dass eine Spreizung des Ätzmittelstrahls 11 nach dem Auftreffen auf die Randfläche 7, die durch ein Wegspritzen des Ätzmittels von der Randfläche 7 verursacht wird, sehr genau kontrolliert werden kann. Dadurch kann die Ätzwirkung des Ätzmittels auf der Randfläche 7 lokal sehr genau begrenzt werden. Zudem wird auf diese Weise verhindert, dass das auf die Randfläche 7 auftreffende Ätzmittel unbeabsichtigt und unkontrolliert die Hauptflächen 3, 4 des Halbleiterkörpers 1 erreicht und diese hierdurch beschädigt.

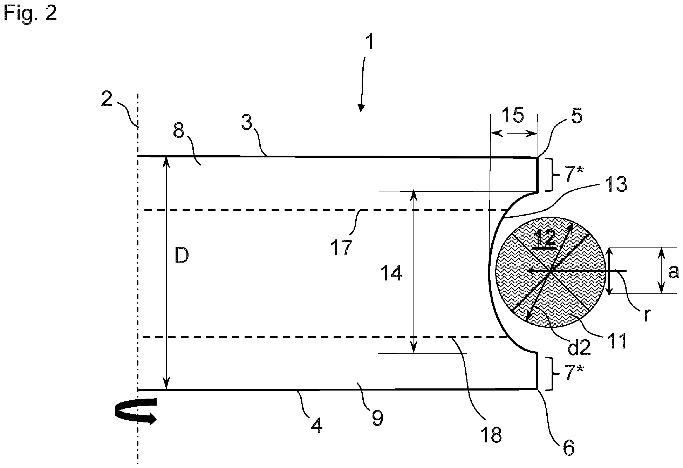

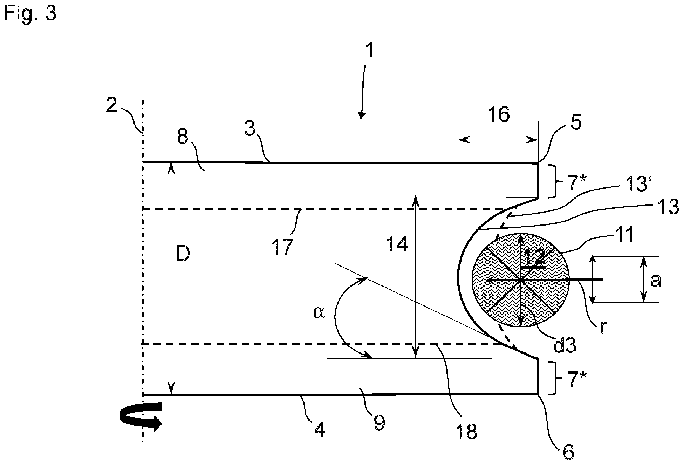

Bei dem in Fig. 1 gezeigten Beispiel kann mittels der tangentialen Führung des Ätzmittelstrahls 11 beispielsweise die raue Oberfläche der gesamten Randfläche 7 oder lediglich eines Teils der Randfläche 7* (wie beispielhaft in Fig. 2 und 3 dargestellt) geglättet werden, wobei der Konturverlauf der Randfläche 7 nach dem Glätten im Wesentlichen (d. h. makroskopisch betrachtet) dem Konturverlauf der Randfläche 7 vor dem Glätten entspricht, d. h. sowohl die ursprüngliche, raue als auch die geglättete Randkontur verläuft im vorliegenden Fall im Wesentlichen parallel zur Mittelachse 2.

Um mit dem Ätzmittelstrahl 11, dessen Durchmesser *d1* kleiner ist als die Dicke *D* des Halbleiterkörpers 1 - bevorzugt maximal 50 % der Dicke *D* des Halbleiterkörpers 1 oder noch bevorzugter maximal 10 % bis 30 % der Dicke *D* - die gesamte Randfläche 7 zu glätten, kann der Ätzmittelstrahl 11 im vorliegend dargestellten Ausführungsbeispiel in einer axialen Verlagerungsrichtung *a* des Halbleiterkörpers 1 verlagert werden. Zum Beispiel kann hierzu eine in Fig. 1 nicht dargestellte Düse zum Ausgeben des Ätzmittelstrahls 11 translatorisch und/oder rotatorisch im Raum verlagert werden, um den Auftreffort des Ätzmittelstrahls 11 auf den Randbereich 7 in axialer Richtung des Halbleiterkörpers 1 (d. h. im Wesentlichen parallel zur Mittel- bzw. Rotationsachse 2) zu verändern.

Um einen Materialabtrag an der Randfläche 7 im gesamten Halbleiterbereich 10 des Halbleiterkörpers 1 zu erzielen, kann der Ätzmittelstrahl 11 ebenfalls in einer radialen Verlagerungsrichtung r im Raum verlagert werden. Auch hierzu kann die in Fig. 1 nicht dargestellte Düse zum Ausgeben des Ätzmittelstrahls 11 translatorisch und/oder rotatorisch im Raum verlagert werden. Die Nachführgeschwindigkeit des Ätzmittelstrahls 11 in radiale Richtung *r* wird hierbei vorzugsweise so gewählt, dass er der durch die Ätzwirkung entstehenden Kontur der Randfläche 7 stets unter Beibehaltung seiner hierin beschriebenen tangentialen Ausrichtung zur Randfläche 7 folgt.

Im vorliegend gezeigten Ausführungsbeispiel ist die Rotationsachse 2 lotrecht im Raum ausgerichtet, ohne jedoch zwingend hierauf beschränkt zu sein. Zum Beispiel kann die Rotationsachse 2 auch um 90 ° zur Richtung der in Fig. 1 gezeigten Rotationsachse 2 gedreht sein, das heißt waagerecht im Raum ausgerichtet sein.

Fig. 2 stellt in einer Seitenansicht des Halbleiterkörpers 1 aus Fig. 1 einen Zwischenschritt nach einer teilweisen Ausführung eines beispielhaften Verfahrens zur Herstellung einer Randstruktur gemäß der Erfindung dar. Es ist zu erkennen, dass ein Teil 7* der Randfläche 7 wie vorstehend zur Fig. 1 erläutert zuerst geglättet wurde. Des Weiteren wurde mithilfe des Ätzmittelstrahls 11 ein Teil einer Randabschrägung 13 geätzt, deren Verlauf von dem ursprünglichen, vor dem Ätzen vorhandenen Konturverlauf der Randfläche 7, makroskopisch betrachtet, verschieden ist. Die in Fig. 2 gezeigte Randabschrägung 13 ist beispielhaft eine doppelt-positive Randabschrägung. Sie ist gegenüber den Hauptflächen 3 und 4 in radialer Richtung zurückversetzt und somit ins Innere des Halbleiterkörpers 1 gerichtet in Form einer Rille, Nut, Hohlkehle o. ä. ausgebildet. In dem in Fig. 2 dargestellten Zwischenschritt wurde ein erster Abschnitt der Randabschrägung 13 mit dem Ätzmittelstrahl 11 und einem Strahldurchmesser *d2* geätzt. Hierzu wurde der Ätzmittelstrahl 11 sowohl in axialer Bewegungsrichtung a als auch in radialer Bewegungsrichtung *r* jeweils bezogen auf den Halbleiterkörper 1 verlagert, wie dies bereits im Zusammenhang mit Fig. 1 erläutert wurde. Im vorliegend dargestellten Beispiel wurde der Strahldurchmesser *d2* größer gewählt als der allein für das Glätten verwendete Strahldurchmesser *d1* in Fig. 1. Der größere Strahldurchmesser *d2* erlaubt beim Ausbilden der sich zu den Rändern 5 und 6 der jeweiligen Hauptflächen 3 bzw. 4 hin öffnenden doppelt-positiven Randabschrägung 13 einen schnellen Materialabtrag, wobei gleichzeitig eine homogene Ätzwirkung auf einen verhältnismäßig breiten Bereich der Randfläche 7 erzielbar ist. Der Strahldurchmesser *d2* kann beispielsweise über einen entsprechend steuerbaren Durchmesser einer Düsenöffnung (nicht dargestellt) oder durch Wahl einer separaten Düse (ebenfalls nicht dargestellt) mit einem entsprechenden Düsendurchmesser festgelegt werden. Der Volumenstrom des Ätzmittelstrahls 11 kann hierbei ebenfalls entsprechend angepasst werden. Wie in Fig. 2 dargestellt ist, weist die Randabschrägung 13 in dem Zwischenzustand eine maximale Höhe 14 auf und eine temporäre Tiefe 15, die von den Rändern 5, 6 der jeweiligen Randflächen 3 bzw. 4 aus bestimmt ist.

Es sei erwähnt, dass der Teil 7* der Randfläche 7 nicht zwingend vorgesehen sein muss. Es ist im Extremfall auch möglich, die maximale Höhe 14 der Randabschrägung 13 gleich der Dicke *D* des Halbleiterkörpers 1 zu wählen, so dass der Teil 7* der Randfläche 7 nicht vorhanden ist.

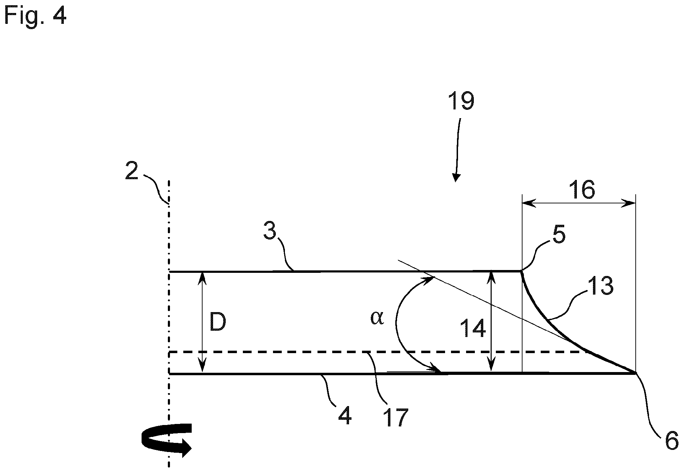

In Fig. 2 ist zu erkennen, dass vorliegend beide pn-Übergänge 17, 18 jeweils die gekrümmte Randkontur der Randabschrägung 13 schneiden, weswegen die Randabschrägung 13 als doppelt-positive Randabschrägung zu bezeichnen ist und die hierin erläuterten Vorteile aufweist. Die Erfindung ist jedoch nicht zwingend auf die doppelt-positive Randabschrägung 13 beschränkt. Es lassen sich mit der Erfindung grundsätzlich auch andere Randabschrägungen herstellen, wie sie beispielsweise für asymmetrisch sperrende Bauelemente wie beispielsweise Diode verwendet werden können, die möglicherweise nur einen pn-Übergang 17 bzw. 18 aufweisen (vgl. Fig. 4).

Fig. 3 stellt eine Seitenansicht des Halbleiterkörpers 1 aus Fig. 2 mit der nach dem Ausführungsbeispiel des erfindungsgemäßen Verfahrens aus Fig. 2 vollständig gefertigten Randstruktur dar. Es ist zu erkennen, dass die Randabschrägung 13 eine endgültige Tiefe 16 erreicht hat, die größer ist als die temporäre Tiefe 15 in Fig. 2. Für einen besseren Vergleich zeigt Fig. 3 als gestrichelte Linie zusätzlich den Verlauf der Randabschrägung 13' aus Fig. 2. Die maximale Breite 14 im endgültig ausgebildeten Zustand der Randabschrägung 13 kann gegenüber dem Zwischenzustand aus Fig. 2 im Wesentlichen unverändert sein. Auch wenn dies eine bevorzugte Variante darstellt, ist die Erfindung nicht zwingend hierauf beschränkt, d. h. die Breite 14 kann sich zwischen dem in Fig. 2 und Fig. 3 gezeigten Zustand unterscheiden, insbesondere in Fig. 3 größer sein als in Fig. 2.

Zur Erzielung der größeren Tiefe 16 in Verbindung mit einem Konturverlauf der Randabschrägung 13, der einen kleinsten Radius am tiefsten, d. h. radial innersten, Punkt aufweist, wurde ausgehend von dem Zustand in Fig. 2 ein Strahldurchmesser *d3* des Ätzmittelstrahls 11 gewählt, der kleiner ist als der Strahldurchmesser *d2* in Fig. 2. Mit diesem lässt sich auch ein gewünschter (optimaler) Schrägungswinkel *α* am Übergang des Teils 7* der Randfläche 7 zum Beginn der Randabschrägung 13 präzise einstellen. Der Winkel *α* wird bevorzugt zwischen etwa 35 ° und 45 ° gewählt. Ist die maximale Breite 14 der Randabschrägung 13 im Wesentlichen gleich der Dicke D des Halbleiterkörpers 1, bezieht sich der Winkel *α* auf den Übergang vom Rand 5 oder 6 zur Randabschrägung 13.

Wie vorstehend anhand der Fig. 1 bis 3 erläutert wurde, kann das Verfahren zur Herstellung der Randstruktur in mehrere einzelne Ätzschritte, insbesondere wenigstens zwei, unterteilt werden, die sich dadurch voneinander unterscheiden, dass zwischen den einzelnen Ätzschritten wenigstens ein Verfahrensparameter verändert wird, der in dem vorstehenden Ausführungsbeispiel den Strahlquerschnitt bzw. Strahldurchmesser d1, d2, d3 des Ätzmittelstrahls 11 betraf. Es ist jedoch zu verstehen, dass auch andere Verfahrensparameter wie beispielsweise der Volumenstrom des Ätzmittelstrahls 11 und/oder die Rotationsgeschwindigkeit des Halbleiterkörpers 1 zusätzlich oder alternativ zum Strahlquerschnitt verändert werden können, wie dies bereits im allgemeinen Teil dieser Beschreibung erläutert wurde.

Abweichend von der vorstehenden Beschreibung des in den Fig. 1 bis 3 gezeigten Ausführungsbeispiel kann ferner der Durchmesser des Strahlquerschnitts 12 des Ätzmittelstrahls 11 während eines ersten Ätzschritts kleiner gewählt werden als der Durchmesser des Strahlquerschnitts 12 während eines zweiten Ätzschritts.

Alternativ oder zusätzlich kann die Rotationsgeschwindigkeit des Halbleiterkörpers 1 während eines ersten Ätzschritts größer gewählt werden als die Rotationsgeschwindigkeit während eines zweiten Ätzschritts.

Alternativ oder zusätzlich kann der Volumenstrom des Ätzmittelstrahls 11 während eines ersten Ätzschritts kleiner gewählt werden als der Volumenstrom während eines zweiten Ätzschritts.

Diese und weitere Kombinationen von Ätzschritten mit unterschiedlichen Verfahrensparametern und einer unterschiedlichen Ausführungsreihenfolge sind denkbar und von der vorliegenden Offenbarung gleichfalls umfasst.

Fig. 4 stellt eine Seitenansicht eines beispielhaften Halbleiterkörpers 19 eines Halbleiterbauelements mit einer nach einem Ausführungsbeispiel des erfindungsgemäßen Verfahrens vollständig gefertigten alternativen Randstruktur 13. Fig. 4 ist zu entnehmen, dass die geätzte Randabschrägung 13 in diesem Fall eine asymmetrische Randabschrägung ist und ohne zwingende Beschränkung hierauf insbesondere eine Randabschrägung mit positivem Winkel. Es ist zu verstehen, dass der in Fig. 4 dargestellte Endzustand der geätzten Randabschrägung 13 mittels des hierin offenbarten erfindungsgemäßen Ätzverfahrens aus einem Halbleiterkörper 1, wie er beispielsweise in Fig. 1 dargestellt ist, erzeugt werden kann.

Die in Fig. 4 dargestellte asymmetrische Randabschrägung 13 kann vorteilhafter Weise bei Halbleiterbauelementen verwendet werden, die nur einen pn-Übergang, zum Beispiel einen einzigen pn-Übergang 17 (vorliegend der zweiten Hauptfläche 4 zugeordnet) aufweisen, beispielsweise eine Diode (d. h. asymmetrisch sperrendes Bauelement). Bei einem symmetrisch sperrenden Bauelement mit wenigstens zwei pn-Übergängen wie beispielsweise ein Thyristor wird bevorzugt die in Fig. 3 dargestellte symmetrische Randabschrägung 13 im Halbleiterkörper 1 vorgesehen.

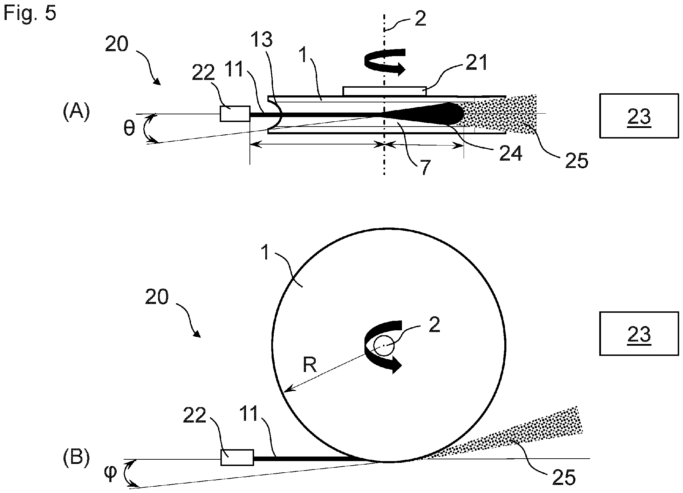

Fig. 5 stellt eine Seitenansicht A eines Ausführungsbeispiels einer Vorrichtung 20 zur Herstellung einer Randstruktur eines Halbleiterbauelements gemäß der Erfindung dar sowie eine Draufsicht B auf die Vorrichtung 20 aus Ansicht A. Es ist zu erkennen, dass die beispielhafte Vorrichtung 20 einen rotierbaren Träger 21 zum Halten eines Halbleiterkörpers, z. B. Halbleiterkörper 1, des Halbleiterbauelements, wenigstens eine steuerbare Düse 22 zum Ausgeben eines Ätzmittelstrahls, z. B. Ätzmittelstrahl 11, mit einem vorbestimmten Strahldurchmesser 12, wie beispielsweise in den Fig. 1 bis 3 dargestellt, sowie eine Steuereinheit 23 aufweist. Die Steuereinheit 23, die beispielsweise eine elektronische Rechen- und Speichereinheit aufweist, ist ausgebildet, den Träger 21 und/oder die wenigstens eine Düse 22 zur Ausführung eines hierin offenbarten erfindungsgemäßen Verfahrens zu steuern. Insbesondere kann die Düse 22 hierzu ausgebildet sein, ihre Lage und/oder Winkelausrichtung im Raum steuerbar zu verändern und/oder Eigenschaften des Ätzmittelstrahls 11 wie Strahlquerschnitt, Volumenstrom, Druck und/oder Temperatur des ausgegebenen Ätzmittels steuerbar zu verändern.

Die Rotationsachse 2 der in Fig. 5 gezeigten Vorrichtung 20 ist beispielhaft lotrecht im Raum ausgerichtet. Wie in Fig. 5 dargestellt ist, ist eine Ausrichtung der Düse 22 im Raum sowohl in einem Horizontalwinkel *ϕ* (Ansicht A) als auch in einem Höhenwinkel *θ* (Ansicht B) steuerbar (rotatorische Verlagerung). Eine translatorische Verlagerung der Düse 22 kann vorgesehen sein, jedoch ist diese nicht zwingend erforderlich.

In einer nicht dargestellten alternativen Ausgestaltung kann auch lediglich eine translatorische Verlagerung der wenigstens einen Düse zum Ausgeben des Ätzmittelstrahls 11 vorgesehen sein und auf eine rotatorische Verlagerung verzichtet werden.

Ferner ist Fig. 5 eine deutliche Spreizung 24 des Ätzmittelstrahls 11 nach dem Auftreffen auf die Randfläche 7 des Halbleiterkörpers 1 zu erkennen. Die Spreizung 24 lässt sich mit dem erfindungsgemäßen Verfahren sowie der erfindungsgemäßen Vorrichtung in der hierin offenbaren Weise gezielt kontrollieren und steuern. Nach der Spreizung des Ätzmittelstrahls 11 auf der Randfläche 7 wird diese infolge der Rotation des Halbleiterkörpers 1 wieder von der Randfläche 7 abgeschleudert. Das weggeschleuderte Ätzmittel ist in Fig. 5 mit dem Bezugszeichen 25 gekennzeichnet.

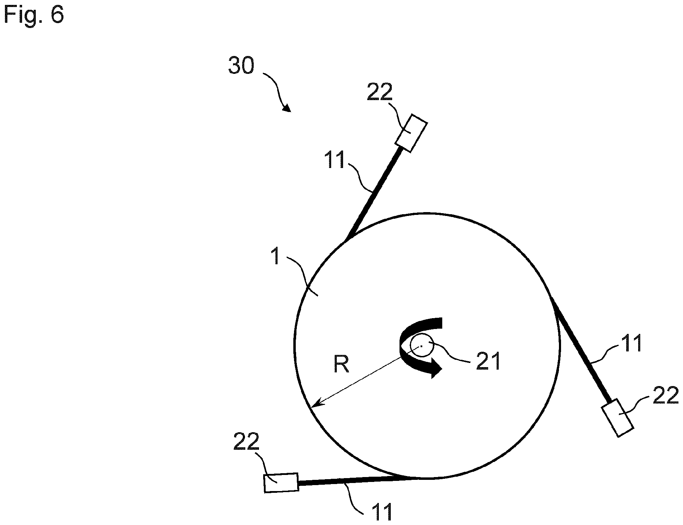

Fig. 6 stellt eine Draufsicht auf ein weiteres Ausführungsbeispiel einer Vorrichtung 30 zur Herstellung einer Randstruktur gemäß der Erfindung dar. Der wesentliche Unterschied der Vorrichtung 30 zur Vorrichtung 20 aus Fig. 5 ist, dass die Vorrichtung 30 mehrere, vorliegend beispielhaft drei, umfänglich um den Träger 21 verteilt angeordnete Düsen 22 aufweist. Die Düsen 22 können in vorteilhafter Weise umfänglich äquidistant angeordnet sein. Die Düsen 22 können wie bei der Vorrichtung 20 aus Fig. 5 steuerbar ausgebildet sein, insbesondere steuerbar in der Lage (translatorisch) und/oder Winkelausrichtung (rotatorisch) im Raum sein und/oder steuerbar in den Eigenschaften des Ätzmittelstrahls 11 wie Strahlquerschnitt, Volumenstrom, Druck und/oder Temperatur des Ätzmittels sein.

Das vorstehend beschriebene erfindungsgemäße Verfahren zur Herstellung einer Randstruktur eines Halbleiterbauelements sowie die erfindungsgemäße Vorrichtung zur Herstellung einer solchen Randstruktur sind nicht auf die hierin jeweils gezeigten Ausführungsformen beschränkt, sondern umfassen auch gleich wirkende weitere Ausführungsformen, die sich aus technisch sinnvollen weiteren Kombinationen der hierin beschriebenen Merkmale der jeweiligen Gegenstände ergeben. Insbesondere sind die vorstehend in der allgemeinen Beschreibung und der Figurenbeschreibung genannten und/oder in den Figuren allein gezeigten Merkmale und Merkmalskombinationen nicht nur in den jeweils hierin explizit angegebenen Kombinationen, sondern auch in anderen Kombinationen oder in Alleinstellung verwendbar und von der vorliegenden Erfindung gleichfalls umfasst.

In besonders bevorzugter Ausführung werden das Verfahren sowie die Vorrichtung zur Herstellung einer Randstruktur eines Halbleiterbauelements zur Ausbildung einer doppelt-positiven Randabschrägung an einer Randfläche eines Halbleiterkörpers des Halbleiterbauelements verwendet, wobei die Randfläche vorteilhafterweise eine Außenumfangsfläche des Halbleiterkörpers sein kann. Das Halbleiterbauelement kann bevorzugt ein symmetrisch sperrendes, insbesondere bipolares Bauelement (d. h. wenigstens zwei pn-Übergänge aufweisend) sein, z. B. ein Thyristor, oder ein asymmetrisch sperrendes, insbesondere bipolares Bauelement (d. h. lediglich einen pn-Übergang aufweisend), wie z. B. eine Diode und dergleichen, und für Sperrspannungen von beispielsweise etwa 3,6 kV und mehr ausgelegt sein. Besonders vorteilhaft können das erfindungsgemäße Verfahren und die erfindungsgemäße Vorrichtung zur Fertigung von Halbleiterbauelementen mit einer Stückzahl von beispielsweise etwa 25.000 pro Jahr und mehr verwendet werden.

## Patentansprüche

1. Verfahren zur Herstellung einer Randstruktur eines Halbleiterbauelements, aufweisend die Schritte:
- Bereitstellen eines Halbleiterkörpers (1) des Halbleiterbauelements, der wenigstens zwei zueinander beabstandete Hauptflächen (3, 4) mit jeweils einem Rand (5, 6) aufweist, zwischen welchen Rändern (5, 6) sich eine Randfläche (7) erstreckt, und
- Ätzen einer vorbestimmten Randkontur durch Auftragen eines chemischen Ätzmittels gezielt auf die Randfläche (7) mittels eines Ätzmittelstrahls (11) bei gleichzeitiger Rotation des Halbleiterkörpers (1) um eine Rotationsachse (2),
wobei der Ätzmittelstrahl (11) mit einem vorbestimmten Strahlquerschnitt (12) derart tangential gerichtet zur Randfläche (7) geführt wird, dass der Ätzmittelstrahl (11) lediglich mit einem Teil seines Strahlquerschnitts (12) auf die Randfläche (7) auftrifft, und
ein Durchmesser (d1) des Ätzmittelstrahls (11) kleiner ist als ein Abstand (D) der die Randfläche (7) begrenzenden Ränder (5, 6) der jeweiligen Hauptflächen (3, 4), wobei der Abstand (D) einer Dicke (D) des Halbleiterkörpers entspricht.

2. Verfahren nach Anspruch 1,
wobei als die Randkontur mittels dem Ätzmittelstrahl (11) eine Randabschrägung (13) geätzt wird, deren Verlauf von einem ursprünglichen, vor dem Ätzen vorhandenen Konturverlauf der Randfläche (7), makroskopisch betrachtet, verschieden ist.

3. Verfahren nach dem vorhergehenden Anspruch,
wobei die geätzte Randabschrägung (13) eine doppelt-positive Randabschrägung ist.

4. Verfahren nach Anspruch 2,
wobei die geätzte Randabschrägung (13) eine asymmetrische Randabschrägung ist.

5. Verfahren nach einem der vorhergehenden Ansprüche,
wobei die Randkontur in wenigstens zwei unterschiedlichen Ätzschritten geätzt wird, wobei zwischen den Ätzschritten wenigstens ein Parameter aus der Gruppe aufweisend einen Durchmesser (d1, d2, d3) des Strahlquerschnitts, einen Volumenstrom des Ätzmittelstrahls und eine Rotationsgeschwindigkeit des Halbleiterkörpers verändert wird.

6. Verfahren nach dem vorhergehenden Anspruch,
wobei in einem ersten Ätzschritt die Randfläche (7) wenigstens teilweise geglättet wird.

7. Verfahren nach einem der beiden vorhergehenden Ansprüche,
wobei in einem letzten Ätzschritt Ablaufspuren des Ätzmittels und/oder Inhomogenitäten auf der Randfläche (7) beseitigt werden.

8. Verfahren nach einem der vorhergehenden Ansprüche,
wobei der maximale Strahlquerschnitt (12) auf einen Durchmesser (d1, d2, d3) von höchstens 50 %, oder zwischen 10 % und 30 %, des Abstands (D) der die Randfläche (7) begrenzenden Ränder (5, 6) der jeweiligen Hauptflächen (3, 4) begrenzt wird.

9. Verfahren nach einem der vorhergehenden Ansprüche,
wobei als die Randkontur mittels dem Ätzmittelstrahl (11) wenigstens ein Teil (7*) der Randfläche (7) lediglich geglättet wird, wobei ein ursprünglicher, vor dem Ätzen vorhandener Konturverlauf des geglätteten Teils (7*) der Randfläche (7), makroskopisch betrachtet, unverändert erhalten bleibt.

10. Verfahren nach einem der vorhergehenden Ansprüche,
wobei eine Rotationsrichtung des Halbleiterkörpers (1) an einem Auftreffort des Ätzmittelstrahls (11) auf die Randfläche (7) im Wesentlichen gleich ist wie eine Strahlrichtung des Ätzmittelstrahls (11).

11. Verfahren nach einem der vorhergehenden Ansprüche,
wobei dem Ätzmittel ein Additiv zur Herabsetzung seiner Oberflächenspannung hinzugefügt wird.

12. Verfahren nach einem der vorhergehenden Ansprüche,
wobei die Rotationsachse (2) lotrecht oder waagerecht im Raum ausgerichtet wird.

13. Vorrichtung zur Herstellung einer Randstruktur eines Halbleiterbauelements, aufweisend einen um eine Rotationsachse (2) rotierbaren Träger (21) zum Halten eines Halbleiterkörpers (1) des Halbleiterbauelements, wenigstens eine steuerbare Düse (22) zum Ausgeben eines Ätzmittelstrahls (11) mit einem vorbestimmten Strahlquerschnitt (12) und eine Steuereinheit (23),
wobei die Steuereinheit (23) ausgebildet ist, den Träger (21) und/oder die wenigstens eine Düse (22) mittels eines Verfahrens gemäß einem der vorhergehenden Ansprüche zu steuern.

14. Vorrichtung nach dem vorhergehenden Anspruch,
wobei die Düse (22) ausgebildet ist, ihre Lage und/oder Winkelausrichtung (θ, ϕ) im Raum steuerbar zu verändern und/oder Eigenschaften des Ätzmittelstrahls (11) wie Strahlquerschnitt, Volumenstrom, Druck und/oder Temperatur steuerbar zu verändern.

15. Vorrichtung nach einem der beiden vorhergehenden Ansprüche,
wobei umfänglich um den Träger (21) mehrere Düsen (22) verteilt, insbesondere äquidistant verteilt, angeordnet sind.

## Claims

1. Method for producing an edge structure of a semiconductor component, comprising the steps:
- providing a semiconductor body (1) of the semiconductor component, which semiconductor body comprises at least two mutually spaced-apart main faces (3, 4) respectively having an edge (5, 6), between which edges (5, 6) an edge face (7) extends, and
- etching a predetermined edge contour by purposely applying a chemical etchant onto the edge face (7) by means of an etchant jet (11) with simultaneous rotation of the semiconductor body (1) about a rotation axis (2),
wherein the etchant jet (11) is guided with a predetermined jet cross section (12), while being directed tangentially with respect to the edge face (7), in such a way that the etchant jet (11) impinges on the edge face (7) only with a part of its jet cross section (12), and
a diameter (d1) of the etchant jet (11) is smaller than a spacing (D) of the edges (5, 6) of the respective main faces (3, 4) delimiting the edge face (7), wherein the spacing (D) corresponds to a thickness (D) of the semiconductor body.

2. Method according to Claim 1,
wherein
as the edge contour, an edge chamfer (13) whose profile is different from an original contour profile of the edge face (7) existing before the etching, considered macroscopically, is etched by means of the etchant jet (11).

3. Method according to the preceding claim,
wherein the etched edge chamfer (13) is a double-positive edge chamfer.

4. Method according to Claim 2,
wherein the etched edge chamfer (13) is an asymmetrical edge chamfer.

5. Method according to one of the preceding claims,
wherein the edge contour is etched in at least two different etching steps, at least one parameter from the group comprising a diameter (d1, d2, d3) of the jet cross section, a volume flow rate of the etchant jet and a rotational speed of the semiconductor body being varied between the etching steps.

6. Method according to the preceding claim,
wherein the edge face (7) is at least partially smoothed in a first etching step.

7. Method according to one of the two preceding claims, wherein running traces of the etchant and/or inhomogeneities on the edge face (7) are eliminated in a last etching step.

8. Method according to one of the preceding claims,
wherein the maximum jet cross section (12) is limited to a diameter (d1, d2, d3) of at most 50%, or between 10% and 30%, of the spacing (D) of the edges (5, 6) of the respective main faces (3, 4) delimiting the edge face (7).

9. Method according to one of the preceding claims,
wherein as the edge contour, at least a part (7*) of the edge face (7) is only smoothed by means of the etchant jet (11), wherein an original contour profile of the smoothed part (7*) of the edge face (7), existing before the etching, is maintained unchanged, considered macroscopically.

10. Method according to one of the preceding claims,
wherein a rotation direction of the semiconductor body (1) at an impingement point of the etchant jet (11) on the edge face (7) is substantially the same as a jet direction of the etchant jet (11).

11. Method according to one of the preceding claims,
wherein an additive is added to the etchant in order to reduce its surface tension.

12. Method according to one of the preceding claims,
wherein the rotation axis (2) is aligned vertically or horizontally in space.

13. Device for producing an edge structure of a semiconductor component, comprising a carrier (21), which can be rotated about a rotation axis (2), for holding a semiconductor body (1) of the semiconductor component, at least one controllable nozzle (22) for delivering an etchant jet (11) having a predetermined jet cross section (12), and a control unit (23), wherein the control unit (23) is configured to control the carrier (21) and/or the at least one nozzle (22) by means of a method according to one of the preceding claims.

14. Device according to the preceding claim,
wherein the nozzle (22) is configured to controllably vary its position and/or angular alignment (θ, ϕ) in space and/or to controllably vary properties of the etchant jet (11), such as jet cross section, volume flow rate, pressure and/or temperature.

15. Device according to one of the two preceding claims, wherein a plurality of nozzles (22) are arranged distributed, in particular equidistantly distributed, circumferentially around the carrier (21).

## Revendications

1. Procédé de production d'une structure de bordure d'un composant à semiconducteur comportant les stades :
- on se procure un corps (1) semiconducteur du composant à semiconducteur, qui a au moins deux surfaces (3, 4) principales à distance l'une de l'autre ayant chacune un bord (5, 6), bords (5, 6) entre lesquels s'étend une surface (7) de bordure, et
- on forme par attaque chimique un contour de bordure déterminé à l'avance par dépôt d'un agent d'attaque chimique, de manière ciblée sur la surface (7) de bordure au moyen d'un faisceau (11) d'agent d'attaque tout en faisant tourner le corps (1) à semiconducteur autour d'un axe (2) de rotation,
dans lequel on envoie le faisceau (11) de l'agent d'attaque, ayant une section (12) transversale de faisceau déterminé à l'avance, de manière dirigée tangentiellement sur la surface (7) de bordure, à ce que le faisceau (11) de l'agent d'attaque n'arrive que par une partie de sa section (12) transversale de faisceau sur la surface (7) de bordure, et
un diamètre (d1) du faisceau (11) de l'agent d'attaque est plus petit qu'une distance (D) entre les bords (5, 6) délimitant la surface (7) de bordure des surfaces (3, 4) principales, la distance (D) correspondant à une épaisseur (D) du corps semiconducteur.

2. Procédé suivant la revendication 1,
dans lequel on attaque, comme contour de bordure, au moyen du faisceau (11) de l'agent d'attaque un biseau (13) de bordure, dont la courbe est, considérée macroscopiquement, différente de la courbe de contour, présente avant l'attaque, de la surface (7) de bordure.

3. Procédé suivant la revendication précédente,
dans lequel le biseau (13) de bordure attaqué est un biseau de bordure doublement positif.

4. Procédé suivant la revendication 2,
dans lequel le biseau (13) de bordure attaqué est un biseau de bordure dissymétrique.

5. Procédé suivant l'une des revendications précédentes,
dans lequel on forme par attaque le contour de bordure, dans au moins deux stades d'attaque différents, dans lequel entre les stades d'attaque, on modifie au moins un paramètre du groupe comportant un diamètre (d1, d2, d3) de la section transversale du faisceau, un courant en volume du faisceau de l'agent d'attaque et une vitesse de rotation du corps semiconducteur.

6. Procédé suivant la revendication précédente,
dans lequel, dans un premier stade d'attaque, on lisse au moins en partie la surface (7) de bordure.

7. Procédé suivant l'une des deux revendications précédentes, dans lequel, dans un dernier stade d'attaque, on élimine des traces d'écoulement de l'agent d'attaque et/ou des défauts d'homogénéité sur la surface (7) de bordure.

8. Procédé suivant l'une des revendications précédentes, dans lequel on limite la section (12) transversale maximum du faisceau à un diamètre (d1, d2, d3) de 50% au plus, ou compris entre 10% et 30% de la distance (D) des bords, (5, 6) délimitant la surface (7) de bordure, des surfaces (3, 4) principales respectives.

9. Procédé suivant l'une des revendications précédentes,
dans lequel on lisse seulement, comme contour de la bordure au moyen du faisceau (11) de l'agent d'attaque, au moins une partie (7*) de la surface (7) de bordure, dans lequel une courbe de contour, présente à l'origine avant l'attaque, de la partie (7*) lissée de la surface (7) de bordure reste, considérée macroscopiquement, inchangée.

10. Procédé suivant l'une des revendications précédentes,
dans lequel un sens de rotation du corps (1) semiconducteur à un endroit d'incidence du faisceau (11) de l'agent d'attaque sur la surface (7) de bordure est sensiblement le même qu'un sens du faisceau (11) de l'agent d'attaque.

11. Procédé suivant l'une des revendications précédentes,
dans lequel on ajoute à l'agent d'attaque un additif pour la diminution de sa tension superficielle.

12. Procédé suivant l'une des revendications précédentes,
dans lequel on dirige l'axe (2) de rotation verticalement ou horizontalement dans l'espace.

13. Installation de production d'une structure de bordure d'un composant à semiconducteur, comportant un support (21) tournant autour d'un axe (2) de rotation pour le maintien d'un corps (1) semiconducteur du composant à semiconducteur, au moins une buse (22) pouvant être commandée pour l'envoi d'un faisceau (11) d'agent d'attaque, ayant une section (12) transversale de faisceau déterminée à l'avance, et une unité (23) de commande,
dans laquelle l'unité (23) de commande est constituée pour commander le support (21) et/ou la au moins une buse (22) au moyen d'un procédé suivant l'une des revendications précédentes.

14. Installation suivant la revendication précédente,
dans laquelle la buse (22) est constituée pour modifier de manière commandée sa position et/ou son orientation (θ, ϕ) angulaire dans l'espace, et/ou pour modifier de manière commandée des propriétés du faisceau (11) de l'agent d'attaque, comme la section transversale du faisceau, le courant en volume, la pression et/ou la température.

15. Installation suivant l'une des deux revendications précédentes,
dans lequel autour du support (21) sont montées plusieurs buses (22), qui sont réparties, en particulier, de manière équidistante.
